# DEMANDE DE BREVET EUROPEEN

(11) **EP 0 562 980 A1**
(43) Date de publication de la demande: **29.09.1993**
(21) Numéro de dépôt: 93420126.0
(22) Date de dépôt: 23.03.1993
(51) Int. Cl.: H01L 23/62, H01L 29/167, H02H 9/04, H02M 3/06

(54) **Pont diviseur auto-protégé**

(30) Priorité: 25.03.1992 FR 9203972
(71) Demandeur: DOLPHIN INTEGRATION (Société Anonyme), F-38242 Meylan (FR)
(72) Inventeur: Compagne, Eric, F-38700 La Tronche (FR)
(74) Mandataire: de Beaumont, Michel

(57) **Abrégé**

La présente invention concerne un pont diviseur auto-protégé réalisé dans un circuit intégré comprenant, dans un substrat (12) d'un premier type de conductivité à faible niveau de dopage, un caisson (11) du deuxième type de conductivité à faible niveau de dopage comprenant une région diffusée (10) du premier type de conductivité formant une résistance et munie de premier et second contacts extrêmes (A, B) et d'un contact intermédiaire (C). Le premier contact (A) est relié à un plot recevant normalement une tension extérieure (V_{H}) supérieure à la tension d'alimentation (VDD) du circuit intégré. Le deuxième contact (B) est relié au potentiel de référence (VSS) du circuit intégré ainsi que le substrat. Le caisson comprend un troisième contact (D) voisin du premier contact et relié à ce premier contact, et un quatrième contact (E) voisin du deuxième contact et relié à ce deuxième contact.

## Description

La présente invention concerne le domaine de la protection contre des surtensions des circuits intégrés et plus particulièrement la protection d'un pont diviseur faisant partie d'un circuit intégré et recevant sur l'une de ses bornes une tension haute plus élevée que la tension d'alimentation de ce circuit intégré.

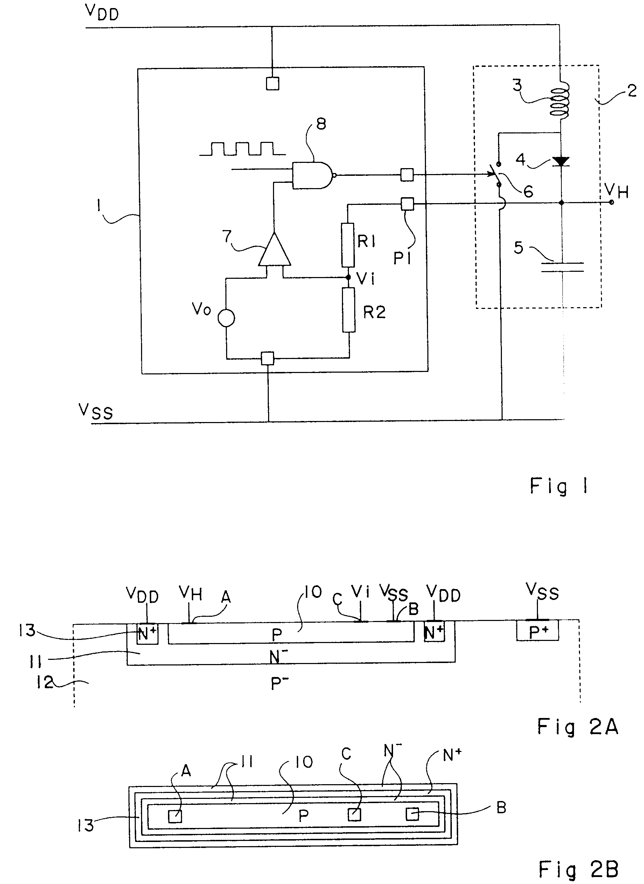

Pour mieux faire comprendre le problème que vise à résoudre la présente invention, la figure 1 représente un exemple de circuit intégré associé à un élévateur de tension.

Dans la figure 1, la référence 1 désigne un circuit intégré alimenté entre des bornes d'alimentation VDD et VSS, par exemple respectivement +3 V et la masse. Un circuit élévateur de tension 2 est également alimenté entre les tensions VDD et VSS. Le circuit 2 comprend par exemple, de façon classique, une bobine 3 en série avec une diode 4 et un condensateur 5. Le point de jonction de la bobine 3 et de la diode 4 est également relié à la masse par l'intermédiaire d'un interrupteur 6 commandé par impulsions. Ainsi, de façon connue, on obtient aux bornes du condensateur 5 une tension V_{H} qui peut atteindre des valeurs supérieures à celles de la tension VDD, par exemple 25 V.

Pour réguler à une valeur constante la tension V_{H}, il convient de moduler convenablement l'interrupteur 6. Pour cela, la tension V_{H} est mesurée, sa valeur est comparée à une valeur de référence et le résultat de cette comparaison détermine l'actionnement de l'interrupteur 6. Cette fonction de régulation est réalisée par une partie du circuit intégré 1.

Dans ce circuit intégré, on peut disposer d'une tension de référence V_{O} qui est inévitablement comprise entre VSS et VDD, par exemple 1,2 volt. Pour effectuer une comparaison entre V_{H} et V_{O}, il faut diviser la valeur V_{H} de façon connue par un pont résistif pour obtenir une valeur Vᵢ, nominalement égale à V_{O}. Ces valeurs V_{O} et Vᵢ sont comparées dans un comparateur 7 qui commande l'une des entrées d'une porte NON ET 8 dont l'autre entrée reçoit par exemple un signal en créneau et dont la sortie détermine l'actionnement de l'interrupteur 6.

Un problème réside dans la réalisation du pont diviseur constitué des résistances R1 et R2. Si ce pont diviseur est externe au circuit intégré, cela ne pose pas de problème particulier. Toutefois, on souhaite généralement intégrer le plus grand nombre possible de composants. Ainsi, comme cela est représenté, on vise à réaliser les composants R1 et R2 à l'intérieur du circuit intégré et donc la tension V_{H} est amenée sur un plot P1 du circuit intégré. Il se pose alors un problème pour protéger ce plot contre d'éventuelles surtensions provenant du circuit élévateur de tension, par exemple des décharges électrostatiques. Ce problème se pose de façon tout à fait spécifique dans ce cas particulier puisque, habituellement, dans un circuit intégré les circuits de protection de plots permettent d'écrêter des surtensions de valeur supérieure à la tension d'alimentation haute VDD alors que, dans le cas particulier considéré, il faut laisser entrer des tensions V_{H} nettement plus élevées que VDD.

On a développé dans l'art antérieur des circuits de protection qui peuvent être associés à des plots recevant des tensions hautes, par exemple du type transistors MOS à isolant de grille épais. Toutefois, la réalisation de tels composants non-usuels est toujours délicate.

Par ailleurs, dans le cadre des circuits intégrés, par exemple des circuits intégrés en technologie CMOS, des résistances peuvent être fabriquées sous forme de bandes polycristallines déposées sur la surface supérieure du substrat et isolées de celui-ci par des couches d'oxyde. On notera que dans le cas particulier où ces résistances doivent recevoir sur l'une de leurs bornes une tension élevée, elles ne peuvent être réalisées sur des couches d'oxyde mince qui claqueraient sous de tel les tensions. De plus, même avec des couches d'oxyde épais, les tensions appliquées sur ces résistances risqueraient de créer des effets capacitifs avec des régions formées dans le substrat et de limiter la fréquence de fonctionnement du système. Un autre inconvénient de ces résistances en silicium polycristallin est qu'elles présentent une faible résistance par carré et donc qu'elles ne se prêtent pas à la réalisation de résistances de valeur élevées. En tout cas, il est nécessaire avec de telles résistances d'associer au plot d'accès un circuit de protection contre des surtensions.

Une autre façon classique de réaliser des résistances dans un circuit intégré consiste à utiliser des bandes diffusées formées dans le substrat.

Un exemple d'une telle résistance est représenté très schématiquement dans la vue en coupe partielle de la figure 2A et dans la vue de dessus de la figure 2B. La résistance est réalisée entre des contacts A et B d'une bande diffusée 10 de type P formée dans un caisson 11 de type N faiblement dopé, lui-même réalisé dans un substrat 12 de type P faiblement dopé. Un contact intermédiaire C sur la bande 10 entre les contacts A et B permettent de disposer d'une prise intermédiaire. Classiquement, le caisson 11 est polarisé au potentiel d'alimentation haute VDD par un contact ménagé sur une région fortement dopée 13, disposée à la périphérie du caisson ou au moins au voisinage du contact sur la bande à potentiel élevé. Le substrat 12 est polarisé au potentiel d'alimentation basse VSS. Les contacts sur les régions faiblement dopées sont assurés par l'intermédiaire de zones de même type de conductivité à plus fort niveau de dopage. Dans cette configuration classique, la résistance est isolée par la jonction entre les régions 10 et 11 mais cet isolement n'est possible que si la tension V_{H} reste inférieure à la tension VDD plus une chute de tension de diode en direct. Dès que V_{H} devient supérieur à VDD, la jonction 10/11 se polarise en direct et il n'y a plus d'isolement. Cette réalisation classique ne convient donc pas à la formation de résistances R1 et R2 pour l'application illustrée en figure 1.

C'est pourquoi, quand on a voulu réaliser des résistances intégrées, on a eu recours classiquement à l'utilisation de résistances en silicium polycristallin avec les inconvénients que cela présente, comme cela a été évoqué ci-dessus.

La présente invention vise à réaliser, dans un circuit intégré, un pont diviseur sous forme de résistances diffusées, ce pont diviseur pouvant avoir l'une de ses bornes reliées à une tension plus élevée que la tension d'alimentation et étant auto-protégé contre des surtensions susceptibles de se produire sur ses bornes.

Pour atteindre ces objets, la présente invention prévoit un pont diviseur auto-protégé réalisé dans un circuit intégré comprenant, dans un substrat d'un premier type de conductivité à faible niveau de dopage, un caisson du deuxième type de conductivité à faible niveau de dopage comprenant une région diffusée du premier type de conductivité formant une résistance et munie de premier et second contacts extrêmes et d'un contact intermédiaire, le premier contact étant relié à un plot recevant normalement une tension extérieure supérieure à la tension d'alimentation du circuit intégré, le deuxième contact étant relié au potentiel de référence du circuit intégré ainsi que le substrat. Selon l'invention, le caisson comprend un troisième contact voisin du premier contact et relié à ce premier contact, et un quatrième contact voisin du deuxième contact et relié à ce deuxième contact.

Selon un mode de réalisation de la présente invention, le contact intermédiaire est relié à la tension d'alimentation du circuit par l'intermédiaire d'un dispositif de protection contre une surtension supérieure à la tension d'alimentation, par exemple une diode, conductrice si la tension sur le contact intermédiaire dépasse la tension d'alimentation.

Selon un mode de réalisation de la présente invention, ladite région diffusée est en forme de bande allongée.

Selon un mode de réalisation de la présente invention, le premier type de conductivité est le type P et le deuxième type de conductivité est le type N.

Ces objets, caractéristiques et avantages ainsi que d'autres de la présente invention seront exposés en détail dans la description suivante de modes de réalisation particuliers faite en relation avec les figures jointes parmi lesquelles :
la figure 1 représente un schéma de circuit destiné à illustrer le problème posé par la présente invention ;
les figures 2A et 2B représentent respectivement une vue en coupe partielle et une vue de dessus de circuit intégré illustrant une résistance diffusée classique et son mode de polarisation ;
les figures 3A et 3B représentent respectivement une vue en coupe et une vue de dessus d'une résistance diffusée selon la présente invention et son mode de polarisation ; et
la figure 4 représente un schéma équivalent du pont diviseur diffusé selon la présente invention et de son mode connexion préférentiel.

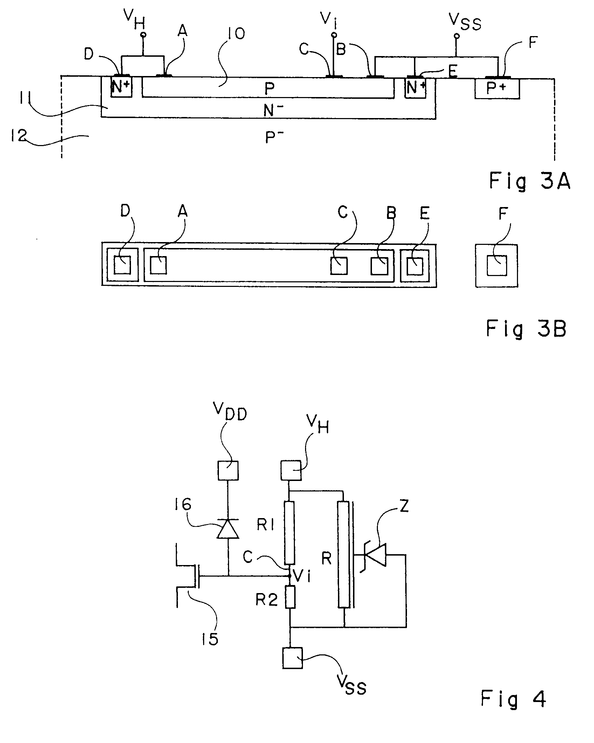

La figure 3A représente une vue en coupe schématique d'un pont diviseur auto-protégé selon la présente invention. Cette vue en coupe ressemble fortement à la vue en coupe de la figure 2A, mais le composant selon l'invention diffère de celui de la figure 2 par son mode de connexion et en particulier par le mode de polarisation du caisson 11.

On retrouve en figure 3A la région diffusée 10 de type P, le caisson 11 de type N⁻, et le substrat 12 de type P⁻. La région diffusée 10 est sensiblement en forme de bande et comprend des contacts extrêmes A et B et un contact intermédiaire C. La région diffusée 11 comprend des contacts extrêmes D et E respectivement voisins des contacts extrêmes A et B de la région diffusée 10. Le substrat comprend une zone de contact F de polarisation au potentiel VSS.

Selon l'invention, le contact D, voisin du contact A, est connecté à ce contact A et le contact E, voisin du contact B, est connecté à ce contact B. On retrouve donc une résistance R1 entre les contacts A et C, une résistance R2 entre les contacts C et B et une résistance R entre les contacts D et E, en parallèle sur l'ensemble des résistances R1 et R2.

On notera une différence fondamentale de fonctionnement entre la structure selon l'invention et l'état de la technique décrit en relation avec la figure 2.

Dans le cas de la figure 2, la jonction qui assure l'isolement de la résistance est la jonction entre les régions 10 et 11, la région 11 de type N étant normalement polarisée plus haut que la région 10 de type P de sorte que la jonction PN est normalement bloquée sauf si accidentellement la tension V_{H} devient supérieure à VDD auquel cas cette jonction devient passante dans le sens direct.

Selon l'invention, les régions 10 et 11 sont sensiblement au même potentiel qui va en décroissant de la valeur V_{H} du côté gauche de la figure vers la valeur VSS du côté droit de la figure. L'isolement de la résistance est assuré par la jonction entre le caisson 11 et le substrat 12, cette jonction étant normalement bloquante puisque la région 11 de type N est à un potentiel positif et la région 12 de type P au potentiel de la masse. La protection est réalisée par mise en avalanche de cette jonction NP quand la différence entre les tensions V_{H} et VSS dépasse la tension d'avalanche de cette jonction NP. Les régions N et P, 11 et 12, résultant des technologies usuelles de fabrication en technologie CMOS, ont des niveaux de dopage tels que leur tension d'avalanche est de l'ordre de 50 à 100 volts, par exemple 80 volts. Ainsi, dans le cas où la tension V_{H} a une valeur élevée normale, la jonction 11/12 est bloquée et quand la tension V_{H} dépasse, par exemple par suite d'une décharge électrostatique, la tension d'avalanche de la jonction 11/12, cette jonction devient passante et l'énergie en excès est absorbée par le substrat vers la masse. Ainsi, la résistance selon la présente invention est auto-protégée sans qu'il soit nécessaire de lui adjoindre un dispositif supplémentaire de protection.

La figure 3B représente un exemple de vue de dessus de la structure de la figure 3A. On notera que les contacts D et E sur le caisson 11 (par l'intermédiaire d'une région surdopée de type N⁺) sont voisins des contacts respectifs A et B avec lesquels ils sont connectés. Bien entendu, la bande de résistance entre les contacts A et B a des dimensions choisies pour supporter la tension appliquée et le contact C est positionné pour obtenir une valeur de tension choisie entre les bornes C et B.

La figure 4 représente un schéma équivalent du circuit selon la présente invention. On y retrouve les plots aux tensions V_{H} et VSS entre lesquels sont disposées les résistances R1 et R2 et en parallèle sur l'ensemble de ces deux résistances une résistance R correspondant à la résistance de la couche 11 entre les contacts D et E. On a représenté, d'une façon distribuée le long de la résistance R une diode à avalanche Z constituée par la jonction NP 11/12, la cathode de cette diode étant connectée du côté de la résistance et l'anode de cette diode étant reliée au plot VSS.

On notera que, dans des applications courantes, le contact C à la tension Vᵢ est connecté à la grille d'un transistor MOS 15 constituant par exemple un transistor d'entrée du comparateur de la figure 1. Il faut donc aussi éviter que ce point C dépasse un niveau déterminé, par exemple la tension d'alimentation VDD du circuit intégré. Pour cela, on pourra utiliser tout dispositif de protection classique. Par exemple, comme cela est représenté en figure 4, la borne C est reliée au plot d'alimentation à la tension VDD par une diode 16 dont l'anode est reliée au contact C et la cathode au plot VDD. Ainsi, si la tension sur le contact C dépasse la tension VDD (plus une chute de tension de diode en direct) la surtension est écrêtée. Ce dispositif est particulièrement utile puisque, comme on l'a vu précédemment, la protection principale n'agit en fait qu'au delà d'un certain seuil relativement élevé (50 à 100 V) et que le point C pourrait dépasser la tension VDD avant que la protection principale n'agisse.

L'homme de l'art notera que la présente invention est susceptible de diverses variantes et de nombreuses applications. Par exemple, dans une transmission bifilaire différentielle, où chacun des fils peut atteindre une tension de crête de 13 volts, un diviseur selon la présente invention pourra être relié à chacun des points d'arrivée des fils vers un circuit intégré ayant une tension d'alimentation de l'ordre de 3 à 5 V. Par ailleurs, tous les types de conductivité pourront être inversés, si les polarités des tensions impliquées le sont également.

A titre d'exemple d'ordres de grandeur, la couche 10 pourra avoir une résistance par carré de 50 à 100 ohms, le substrat 12 un niveau de dopage de 5. 10¹⁵ atomes/cm³ et la couche 11 un niveau de dopage de 5. 10¹⁶ atomes/cm³.

## Revendications

1. Pont diviseur auto-protégé réalisé dans un circuit intégré comprenant, dans un substrat (12) d'un premier type de conductivité à faible niveau de dopage, un caisson (11) du deuxième type de conductivité à faible niveau de dopage comprenant une région diffusée (10) du premier type de conductivité formant une résistance et munie de premier et second contacts extrêmes (A, B) et d'un contact intermédiaire (C), le premier contact (A) étant relié à un plot recevant normalement une tension extérieure (V_{H}) supérieure à la tension d'alimentation (VDD) du circuit intégré, le deuxième contact (B) étant relié au potentiel de référence (VSS) du circuit intégré ainsi que le substrat, caractérisé en ce que le caisson comprend un troisième contact (D) voisin du premier contact et relié à ce premier contact, et un quatrième contact (E) voisin du deuxième contact et relié à ce deuxième contact.

2. Pont diviseur selon la revendication 1, caractérisé en ce que le contact intermédiaire est relié à la tension d'alimentation du circuit par l'intermédiaire d'un dispositif de protection contre une surtension supérieure à la tension d'alimentation.

3. Pont diviseur selon la revendication 2, caractérisé en ce que le dispositif de protection est une diode (16), conductrice si la tension sur le contact intermédiaire dépasse la tension d'alimentation.

4. Pont diviseur selon la revendication 1, caractérisé en ce que ladite région diffusée est en forme de bande allongée.

5. Pont diviseur selon la revendication 1, caractérisé en ce que le premier type de conductivité est le type P et le deuxième type de conductivité est le type N.
